# EUROPÄISCHE PATENTANMELDUNG

(11) **EP 4 749 298 A1**
(43) Veröffentlichungstag der Anmeldung: **27.05.2026**
(21) Anmeldenummer: 25216905.7
(22) Anmeldetag: 19.11.2025
(51) Int. Cl.: G01R 1/20, G01R 31/28, G01R 31/34, G01R 31/385

(54) **PRÜFFELD MIT MODULAREM GLEICHSPANNUNGS-BUS**

(30) Priorität: 22.11.2024 DE 102024211239; 20.03.2025 DE 102025110881
(71) Anmelder: ZF Friedrichshafen AG, 88046 Friedrichshafen (DE)
(72) Erfinder: GOTTSCHALLER, Sebastian, 94113 Tiefenbach (DE); STUEBENER, Dirk, 80995 München (DE)
(74) Vertreter: ZF Friedrichshafen AG

(57) **Zusammenfassung**

Ein Prüffeld (2) zum elektrischen Test von Prüflingen (4) mit Hilfe elektrischer Stark-Leistung unter Gleichspannung (UG), enthält wenigstens eine Energiequelle (12) mit einem Generator (14) für Wechselspannung (UW) und einem Umrichter (16) mit ersten zweipoligen Gleichspannungs-Schnittstellen (18), und Prüfstationen (20) für die Prüflinge (4) mit einem Resonanzkonverter (22) mit einer zweiten zweipoligen Gleichspannungs-Schnittstelle (26) und einem Tiefsetzsteller (24) mit einem zweipoligen Gleichspannungs-Anschluss (28) für den Prüfling (4), und einen modularen Gleichspannungs-Bus (30) mit einer Reihenschaltung von Gleichverteilern (34) mit in Reihe schaltbaren Stromschienen (32) und Abzweigen (36), die von der Stromschiene (32) zu dritten zweipoligen Gleichspannungs-Schnittstelle (38) führen, mit Trennschaltern (40), wobei jede der ersten (18) und zweiten Gleichspannungs-Schnittstellen (26) jeweils an einer der dritten Gleichspannungs-Schnittstellen (38) angeschlossen ist.

## Beschreibung

Die Erfindung betrifft ein Prüffeld. Ein hier in Rede stehendes Prüffeld dient zur elektrischen Prüfung von Prüflingen, z.B. elektrischen Antrieben oder Fahrbatterien von Elektrofahrzeugen, unter Gleichspannung zwischen zwei Polen bei vergleichsweise hohen Leistungen im Zig-kW-Bereich. An mehreren Prüfstationen des Prüffeldes ist jeweils einer der Prüflinge anschließbar bzw. angeschlossen. Dabei können die Prüflinge elektrische Leistung aus der Prüfstation aufnehmen und / oder an diese abgeben.

Aus der WO 2021 / 174278 A1 ist es bekannt, dass elektrisch betriebene Prüfstände regelmäßig Umrichteranordnungen mit mehreren Umrichtern umfassen, sei es nun für die Prüfung der Antriebsstränge von Elektrofahrzeugen, Hybridfahrzeugen, herkömmlichen Fahrzeugen mit Verbrennungsmotor, der mechanischen Komponenten wie dem Getriebe, oder den Batteriespeichern selbst. Gerade die Prüfung der Batteriespeicher erfolgt oft parallel, wobei mehrere Batteriezellen, Batteriemodule oder Batteriepacks gleichzeitig mit parallel angeordneten Umrichtern geprüft werden.

Aufgabe der Erfindung ist es, Verbesserungen in Bezug auf ein Prüffeld vorzuschlagen.

Die Aufgabe wird gelöst durch ein Prüffeld gemäß Patentanspruch 1. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Das Prüffeld ist ein solches für zweipolige Prüflinge, dient also zur Prüfung bzw. zum Anschluss von zweipoligen Prüflingen. Die beiden Pole bilden einen Plus- und einen Minuspol für eine Gleichspannung. Das Prüffeld dient zum elektrischen Test der Prüflinge. Getestet werden die Prüflinge unter Gleichspannung zwischen den beiden Polen mithilfe eines in den jeweiligen Prüfling einzuspeisenden und / oder aus diesem abzuführenden elektrischen Stromes. Dabei ist das Prüffeld so dimensioniert, dass der Prüfung einer vergleichsweise starken elektrischen Leistung ausgesetzt werden kann. Das Prüffeld ist hierbei für vergleichsweise starke elektrische Belastungen der Prüflinge ausgelegt. Der Nennwert / Maximalwert der möglichen elektrischen Leistung pro Prüfling beträgt typisch 250 kW bis 1 MW, bei einer Nennspannung von typisch ca. 200 V bis ca. 800 V und einem Nennstrom von, typisch 1000 A bis 2000A.

Das Prüffeld enthält wenigstens eine Energiequelle. Die Energiequelle kann elektrische Leistung in das restliche Prüffeld speisen, ggf. auch aus diesem aufnehmen. Die Begriffe "Quelle / Erzeugung / usw." sind hier also weit zu verstehen: Die "Energiequelle" z.B. ist hier ggf. bidirektional ausgelegt und bei Bedarf auch als Energiesenke betreibbar.

Jede der Energiequellen enthält einen (ggf. bidirektionalen) Generator. Der Generator dient zur Erzeugung einer Wechselspannung für das restliche Prüffeld. Jede der Energiequellen enthält außerdem wenigstens einen Umrichter, welcher an den Generator angeschlossen ist. Der Umrichter dient zur Umrichtung zwischen der am Generator anliegenden Wechselspannung und einer Gleichspannung. An der dem Generator abgewandten Seite (schaltungstechnisch gesehen) enthält daher der jeweilige Umrichter bzw. die jeweilige Energiequelle wenigstens eine erste zweipolige Gleichspannungs-Schnittstelle.

Das Prüffeld enthält außerdem eine Mehrzahl von Prüfstationen. Jede der Prüfstationen dient zur Prüfung bzw. zum Anschluss je eines Prüflings. Auch die Prüfstationen sind zweipolig ausgeführt, um einen Prüfling zweipolig anzuschließen und so mit Gleichspannung zu versorgen. Jede der Prüfstationen enthält einen Resonanzkonverter. Der Resonanzkonverter bzw. die Prüfstation weist eine zweite zweipolige Gleichspannungs-Schnittstelle auf. Jede der Prüfstationen enthält einen Tiefsetzsteller, der an den jeweiligen Resonanzkonverter angeschlossen ist. An der dem Resonanzkonverter abgewandten Seite (schaltungstechnisch, siehe oben) weist die Prüfstation bzw. der Tiefsetzsteller einen zweipoligen Gleichspannungs-Anschluss auf. Dieser dient zum zweipoligen Anschluss des jeweiligen Prüflings.

Resonanzkonverter und Tiefsetzsteller dienen dazu, die Gleichspannung an der zweiten zweipoligen Gleichspannungs-Schnittstelle über eine Zwischen-Wechselspannung in eine niedrigere Gleichspannung am Gleichspannungs-Anschluss umzusetzen (ggf. bidirektional).

Das Prüffeld enthält einen modularen Gleichspannungs-Bus.

Der Gleichspannungs-Bus enthält eine Reihenschaltung von mindestens zwei Gleichverteilern. Jeder der Gleichverteiler enthält eine zweipolig ausgeführte Stromschiene. Die Gleichverteiler sind bezüglich ihrer Stromschienen in Reihe schaltbar. D.h., durch Reihenschaltung der zweipoligen (Teil-)Stromschienen pro Gleichverteiler entsteht eine gemeinsame über alle in Reihe geschaltete Gleichverteiler durchgängige zweipolige (Gesamt-)Stromschiene.

Jeder der Gleichverteiler enthält wenigstens zwei Abzweige. Jeder der Abzweige ist zweipolig ausgeführt und zweipolig an der Stromschiene angeschlossen. Jeder der Abzweige führt von der Stromschiene daher zu einer jeweiligen dritten zweipoligen Gleichspannungs-Schnittstelle. Mit anderen Worten mündet jeder Abzweig in eine dritte Gleichspannungs-Schnittstelle seiner selbst bzw. des Gleichverteilers.

Jeder der Abzweige enthält einen zweipoligen Trennschalter. Durch den Trennschalter ist also die jeweilige dritte Gleichspannungs-Schnittstelle elektrisch zweipolig und damit vollständig von der Stromschiene trennbar oder elektrisch an diese anschließbar / mit dieser verbindbar.

Im Prüffeld ist jede der ersten und jede der zweiten Gleichspannungs-Schnittstellen jeweils an einer der dritten Gleichspannungs-Schnittstellen angeschlossen. So sind also alle Energiequellen und Prüfstationen über den Gleichspannungs-Bus miteinander elektrisch leitend zweipolig verbunden.

Bevorzugt weist wenigstens einer der Gleichverteiler genau sechs Abzweige auf. Insbesondere ist an einem der Gleichverteiler eine Energiequelle an insgesamt vier seiner Abzweige angeschlossen. An den restlichen beiden Abzweigen ist dann je eine Prüfstation angeschlossen bzw. anschließbar.

Grundsätzlich kann aber eine beliebige und im konkreten Anwendungsfall jeweils geeignete Anzahl von Gleichverteilern vorgesehen sein.

Durch die Modularität des Gleichspannungs-Buses kann das Prüffeld im Rahmen einer Projektierung durch das Anschalten / Wegnehmen weiterer Gleichverteiler in Reihenschaltung einfach skaliert werden. Dank der Trennschalter lassen sich einzelne Abzweige selektiv freischalten, ohne andere Abzweige freizuschalten. Zum Beispiel kann so bei einem der Abzweige der Trennschalter geöffnet werden, sodass dort z.B. die angeschlossene Prüfstation abgenommen oder ausgetauscht oder an dieser Wartungsarbeiten durchgeführt werden können, da diese spannungsfrei geschaltet ist. Die anderen Prüfstationen bzw. das restliche Prüffeld kann dabei weiter betrieben werden.

In einer bevorzugten Ausführungsform weist wenigstens einer der Trennschalter eine Sicherungsvorrichtung gegen Wiedereinschalten auf. Somit kann - nach Öffnen des Trennschalters - in fachüblicher Weise sichergestellt werden, dass ein Wiedereinschalten des Trennschalter sicher verhindert ist. Arbeiten an einer Energiequelle oder Prüfstation, die an der betreffenden dritten Gleichspannungs-Schnittstelle angeschlossen sind, sind somit gefahrlos möglich. Die Sicherungsvorrichtung ist z.B. ein Befestigungsmittel für ein bei Vorhandensein / Anbringung das Wiedereinschalten des Trennschalters verhinderndes Vorhängeschloss.

In einer bevorzugten Ausführungsform enthält wenigstens einer der Abzweige wenigstens einen, insbesondere zwei Brückenanschlüsse. In anderen Worten weist also zumindest ein Abzweig zumindest einen Brückenanschluss auf. Jeder der Brückenanschlüsse ist bezüglich eines der beiden Pole wirksam. Der Brückenanschluss trennt die betreffende Polleitung, also die elektrische Verbindung eines Pols der Stromschiene mit einem Pol der dritten Gleichspannungs-Schnittstelle, auf. In den Brückenanschluss ist wahlweise ein Kurzschlusselement (dann ein Element des Prüffeldes) einsetzbar, um diesen zu überbrücken. Die elektrische Verbindung des Pols über den Brückenanschluss ist damit wiederhergestellt. Alternativ ist ein Sicherungselement (dann ein Element des Prüffeldes) in den Brückenanschluss einsetzbar, um diesen zu überbrücken. Ein elektrisches Sicherungselement, zum Beispiel eine elektrische Schmelzsicherung, sichert dann den entsprechenden Pol und damit die dritte Gleichspannungs-Schnittstelle bzw. den gesamten Abzweig elektrisch ab, zum Beispiel gegen Überstrom.

Kurzschlusselement oder Sicherungselement überbrücken also den jeweiligen Brückenanschluss und stellen die elektrische Verbindung zwischen der dritten Schnittstelle und der Stromschiene bezüglich dieses Pols (gegebenenfalls elektrisch abgesichert oder per Kurzschluss) wieder her. Die Abzweige sind somit universell einsetzbar, insbesondere zum Anschluss einer Energiequelle (Einsetzen eines Kurzschlusselements) oder einer Prüfstation (Einsetzen eines elektrischen Sicherungselements). Mit anderen Worten sind die Abzweige somit konfigurierbar.

In einer bevorzugten Ausführungsform enthält das Prüffeld insbesondere genau eine Vorladeeinrichtung. Die Vorladeeinrichtung ist wahlweise bzw. bei Bedarf mit insbesondere genau einer der Prüfstationen verbindbar. Die Vorladeeinrichtung ist dazu eingerichtet, in die Prüfstation, mit der sie aktuell verbunden ist, eine elektrische Vorladung einzuspeisen. Dies geschieht insbesondere vor der Anschaltung der Prüfstation an das restliche Prüffeld. Die Anschaltung erfolgt durch Herstellung der elektrischen Verbindungen zu den Stromschienen, also Schließen des Trennschalters. Die Vorladeeinrichtung kann somit zum Beispiel dann angeschlossen und aktiviert werden, wenn die betreffende Prüfstation mit ihrer zweiten Schnittstelle bereits an der dritten Schnittstelle angeschlossen ist, der Trennschalter jedoch noch geöffnet ist. Durch eine entsprechende Vorladung eventueller Kapazitäten in der Prüfstation ist somit ein sicheres Schließen des Trennschalters bzw. Herstellen der Verbindung der Prüfstation mit der Stromschießschiene möglich, ohne dass z.B. wegen aufzuladender oder zu entladender Kapazitäten in der Prüfstation stoßförmiger Stromfluss über den Abzweig erfolgt.

In einer bevorzugten Ausführungsform weist wenigstens eine der Energiequellen eine Mehrzahl, insbesondere vier, zweipolige erste Gleichspannungs-Schnittstellen auf. Mit anderen Worten ist die Energiequelle bzw. ist oder sind deren Umrichter über mehrere parallele zweipolige Schnittstellen mit dem Gleichstrom-Bus / der Stromschiene verbunden, sodass die jeweilige Strombelastung der Schnittstellen reduziert ist. So kann beispielsweise eine Energiequelle mit Nennleistung 1MW in vier zweipolige Module / Anschlüsse zu je 250kW aufgeteilt werden.

In einer bevorzugten Ausführungsform sind alle Gleichverteiler gleich ausgeführt. Somit entsteht ein besonders universelles Konzept für eine Skalierbarkeit des Prüffeldes.

In einer bevorzugten Ausführungsform enthält das Prüffeld wenigstens zwei Energiequellen. Somit kann jede der Energiequellen mit einer niedrigeren Nennleistung ausgeführt werden, um dennoch eine erhöhte Gesamt-Nennleistung für das Prüffeld zur Verfügung zu stellen.

In einer bevorzugten Variante dieser Ausführungsform sind wenigstens zwei der Energiequellen an zwei verschiedenen Gleichverteilern angeschlossen. Somit wird die Einspeisung bzw. elektrische Belastung der Gleichverteiler durch Energiequellen bzw. deren Anschluss reduziert.

In einer bevorzugten Ausführungsform ist an wenigstens einem der Gleichverteiler keine Energiequelle angeschlossen. Somit stehen an diesem Gleichverteiler besonders viele dritte Gleichspannungs-Schnittstellen zum Anschluss von Prüfstationen zur Verfügung.

Die Erfindung beruht auf folgenden Erkenntnissen, Beobachtungen bzw. Überlegungen und weist noch die nachfolgenden bevorzugten Ausführungsformen auf. Diese Ausführungsformen werden dabei teils vereinfachend auch "die Erfindung" genannt. Die Ausführungsformen können hierbei auch Teile oder Kombinationen der oben genannten Ausführungsformen enthalten oder diesen entsprechen und/oder gegebenenfalls auch bisher nicht erwähnte Ausführungsformen einschließen.

Gemäß der Erfindung ergibt sich damit ein DC-Verteiler (DC: direct current / Gleichstrom), insbesondere ein DC-Verteiler für DC-Zwischenkreise mit selektiver Trenn- und Vorladeeinrichtung.

Die Erfindung beruht auf folgender Beobachtung in der Praxis:
Es gibt eine direkte Verbindung der Geräte im DC-Zwischenkreis (Stromschiene). Der komplette Zwischenkreis (Stromschiene) muss daher für Wartungszwecke abgeschaltet werden. Gemäß der Erfindung muss der Zwischenkreis (Stromschiene) nicht abgeschaltet werden. Dies beruht auf der selektiven Freischaltung (Trennschalter) und Vorladung (Vorladeeinrichtung) der einzelnen DC-Abgänge (Abzweige).

Die Erfindung befasst sich mit folgenden Topologien: Bei den betrachteten Geräten handelt es sich um hochdynamische, rückspeisfähige DC-Spannungsquellen und - senken (Prüfstation) für den Test von elektrischen Komponenten (Prüfling) und zur Simulation von Batterien und anderen elektrischen Speichern in Prüfständen (Prüfmodul). Typische Prüflinge sind dabei Antriebs- und Speicherkomponenten wie Batterien, elektrische Antriebe, Stromrichter, Brennstoffzellen, Solarzellen oder Supercaps.

Bei den betrachteten Topologien wird aus den Abgangs-Schienen (Stromschiene / Gleichspannungs-Anschluss) jeweils eine hohe DC-Leistung (typ. 250kW bis 1MW) bei hohen Spannungen (bis 1500V) und hohen Strömen (bis 2000A) bereitgestellt.

Dank eines DC-Zwischenkreis-Busses (Gleichspannungs-Bus) ist ein gemeinsamer DC-Zwischenkreis über mehrere Prüfstände (Prüfstationen) hinweg realisierbar.

Die Erfindung beruht auf folgenden Erkenntnissen:
Insbesondere in großen Prüffeldern bietet ein zentraler DC-Zwischenkreis (Gleichspannungs-Bus) über das gesamte Prüffeld diverse Vorteile.

Der bei den Prüfungen typischerweise auftretende alternierende Leistungsfluss durch den Prüfling (Laden/Entladen, Beschleunigen/Rekuperieren) kann so bereits im Zwischenkreis ausgeglichen werden, wodurch der Netzanschluss (erste Gleichspannungs-Schnittstelle) des Prüffelds deutlich reduziert werden kann im Vergleich zum herkömmlichen Ansatz

Ein Nachteil dieses Systems ist jedoch, dass zu Wartungs- und Reparaturzwecken einer Prüfstation (auch "DCU": DC-Unit, Leistungseinheit bestehend aus einem RK und TSB, RK: Resonanzkonverter: Leistungsmodul zur Potentialtrennung (Transformatorprinzip) / TSB: Tiefsetzstellerbrücke: Leistungsmodul zur Regelung der Ausgangsspannung) das komplette Prüffeld, bzw. alle DCUs (Prüfstationen), die von einem UWR ("Umrichter": Universal Wechselrichter / Netzumrichter: Erzeugt den DC-Zwischenkreis) versorgt werden, freigeschaltet werden müssen, um die Personen-Sicherheit während der Arbeiten gewährleisten zu können.

Grundidee der Erfindung ist daher folgende:
Anstatt einer direkten Kopplung der DCUs (Prüfstationen) und des UWR (Umrichter) untereinander, wird die DC-Leistung über einen modularen DC-Verteiler (modularer Gleichspannungs-Bus) geführt, der es erlaubt die einzelnen DC-Pfade (Abzweige) selektiv freizuschalten (Trennschalter) und gegen Wiedereinschalten zu sichern (Sicherungsvorrichtung gegen Wiedereinschalten).

Die in DC-Netzen typischerweise auftretenden hohen Einschaltströme beim Wieder-Zuschalten (Anschalten eines Prüfmoduls an die Stromschienen) aufgrund der großen verbauten Zwischenkreis-Kapazitäten, werden mit einer speziellen Vorlade-Einrichtung reduziert. Hier kommt ebenfalls ein modularer Ansatz zum Tragen, der eine Vorladeeinrichtung für mehrere DC-Pfade (Abzweige / Prüfmodule) nutzbar macht, da es nicht die Anforderung ist mehrere DCUs (Prüfmodule) gleichzeitig zuzuschalten.

Die Anschlüsse (Abzweige) können entweder mit DC-Sicherungen (Sicherungselement in einem Brückenanschluss), um eine DCU (Prüfstation) anzuschließen, oder mit einer Brücke (Kurzschlusselement in einem Brückenanschluss) bestückt werden, um eine Energiequelle anzuschließen.

Die DC-Sicherungen eines Strompfades sind von benachbarten Strompfaden abgeschottet, so dass ein Sicherungswechsel (Sicherungselement) an einem einzelnen abgeschalteten Strompfad (Brückenanschluss in einem Abzweig mit geöffnetem Trennschalter) möglich ist.

Weitere Merkmale, Wirkungen und Vorteile der Erfindung ergeben sich aus der nachfolgenden Beschreibung eines bevorzugten Ausführungsbeispiels der Erfindung sowie den beigefügten Figuren. Dabei zeigen, jeweils in einer schematischen Prinzipskizze:
- Figur 1: ein Prüffeld mit zwei Prüfstationen und einer Energiequelle in einem schematischen Blockschaltbild,
- Figur 2: das Prüffeld aus Figur 1, erweitert um eine Energiequelle und acht Prüfstationen mit dem detaillierteren Gleichspannungs-Bus mit Gleichverteilern,
- Figur 3: eine Detaildarstellung eines Ausschnitts aus dem Prüffeld aus Figur 2 mit dem mittleren der Gleichverteiler.

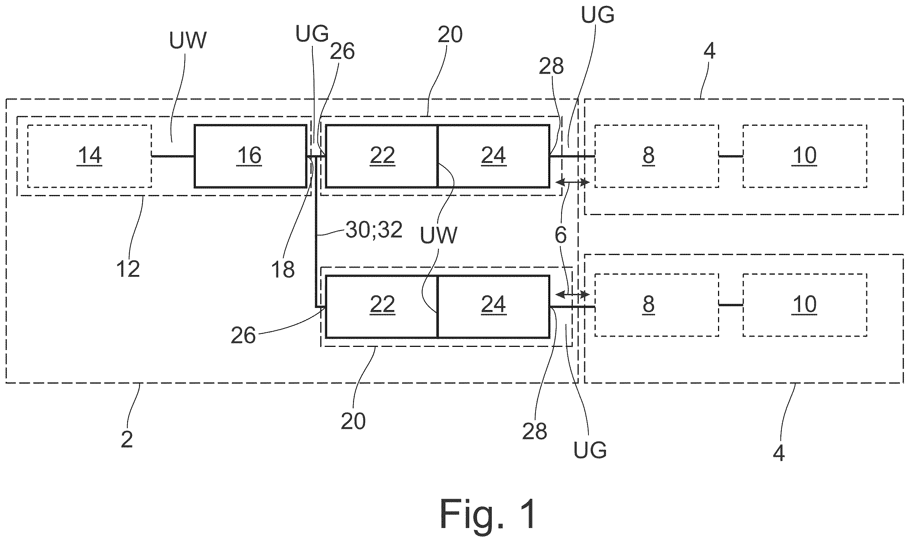

Figur 1 zeigt ein Prüffeld 2 für zweipolige Prüflinge 4. Im Beispiel sind tatsächlich zwei Prüflinge 4 am Prüffeld 2 angeschlossen. Mithilfe des Prüffeldes 2 wird ein elektrischer Test an den Prüflingen 4 durchgeführt. Hierzu wird eine elektrische Stark-Leistung 6, hier von bis zu 1MW - je nach Test - in den Prüflingen 4 eingespeist oder aus diesem abgeführt. Die Stark-Leistung 6 ist im Beispiel durch einen Doppelpfeil gekennzeichnet.

Im Beispiel ist jeder der Prüflinge 4 in Form einer Prüfvorrichtung 8, hier einer sogenannten DC-Box, und dem eigentlichen Prüfling in Form eines DUT 10 (Device Under Test) dargestellt. Die beiden DUTs 10 sind vorliegend eine Fahrbatterie und ein Antriebsmotor eines Elektrofahrzeugs. Die DC-Box dient dem Anschluss des DUT 10 an das Prüffeld 2.

Das Prüffeld 2 enthält eine Energiequelle 12, die wiederum einen Generator 14 sowie einen Umrichter 16 enthält. Der Generator 14 stellt im Betrieb eine Wechselspannung UW bereit, hier im Beispiel eine dreiphasige Wechselspannung von 400 V. Der Umrichter 16 ist an den Generator 14 angeschlossen und dient dazu, die Wechselspannung UW in eine Gleichspannung UG umzurichten, welche er an einer ersten zweipoligen Gleichspannungs-Schnittstelle 18 des Umrichters 16 bzw. der Energiequelle 12 anliegt.

Das Prüffeld 2 enthält außerdem zwei jeweils zweipolige Prüfstationen 20. Jede der Prüfstationen 20 dient zum Anschluss genau eines der Prüflinge 4.

Jede der Prüfstationen 20 enthält einen Resonanzkonverter 22 sowie einen Tiefsetzsteller 24. Der Resonanzkonverter 22 bzw. die Prüfstation 20 weist eine zweite zweipolige Gleichspannungs-Schnittstelle 26 auf. Der Tiefsetzsteller 24 bzw. die Prüfstation 20 weist an der dem Resonanzkonverter 22 abgewandten Seite einen zweipoligen Gleichspannungs-Anschluss 28 für den jeweiligen Prüfling 4 auf. Der Resonanzkonverter 22 konvertiert die Gleichspannung UG an der zweiten Gleichspannungs-Schnittstelle 26 in eine Wechselspannung UW, und wieder zurück in eine Gleichspannung, welche vom Tiefsetzsteller 24 wiederum in eine Gleichspannung UG variabler Höhe am Gleichspannungs-Anschluss 28 umgesetzt wird.

Das Prüffeld 2 enthält außerdem einen modularen Gleichspannungs-Bus 30 mit einer zweipoligen Stromschiene 32. Die erste Gleichspannungs-Schnittstelle 18 und die zweiten Gleichspannungs-Schnittstellen 26 sind an dem Gleichspannungs-Bus 30 angeschlossen, wie weiter unten näher erläutert wird. So verteilt der Gleichspannungs-Bus 30 bzw. die Stromschiene 32 die Gleichspannung UG zwischen der Energiequelle 12 und den Prüfstationen 20.

Der Gleichspannungs-Bus 30 realisiert somit einen Gleichspannungs-Zwischenkreis im Prüffeld 2 und führt hier im Betrieb eine Gleichspannung UG von 825 V.

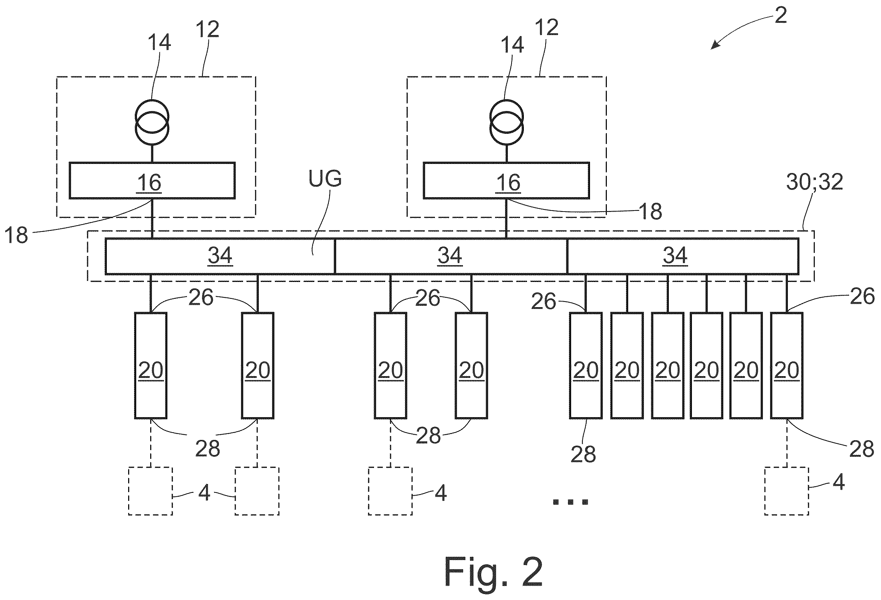

Figur 2 zeigt das Prüffeld 2 aus Figur 1 als Teil eines alternativen Prüffeldes 2. Das alternative Prüffeld 2 ist gegenüber dem aus Figur erweitert und enthält neben demjenigen aus Figur 1 eine zweite Energiequelle 12 identisch zur ersten Energiequelle 12, sowie acht weitere Prüfstationen 20 identisch zu den Prüfstationen 20 aus Figur 1. Alle Energiequellen 12 und Prüfstationen 20 sind über ihre jeweiligen ersten Gleichspannungs-Schnittstellen 18 und zweiten Gleichspannungs-Schnittstellen 26 an dem Gleichspannungs-Bus 30 bzw. der Stromschiene 32 angeschlossen.

Figur 2 zeigt nun jedoch im Detail, dass bzw. wie der Gleichspannungs-Bus 30 aus insgesamt drei Gleichverteilern 34 modular aufgebaut ist. Die Gleichverteiler 34 sind in Reihe geschaltet. Jeder der Gleichverteiler 34 enthält die bzw. eine zweipolige Stromschiene 32, wobei die jeweiligen Stromschienen 32 elektrisch in Reihe geschaltet sind, sodass sich eine einzige über alle drei Gleichverteiler 34 durchgehende zweipolige Stromschiene 32 bildet, wie weiter unten noch näher erläutert wird.

Das Prüffeld 2 enthält hier also zwei Energiequellen 12. Die beiden Energiequellen 12 sind an verschiedenen Gleichverteilern 34 angeschlossen. An einem der Gleichverteiler 34 ist keine der Energiequellen 12 angeschlossen.

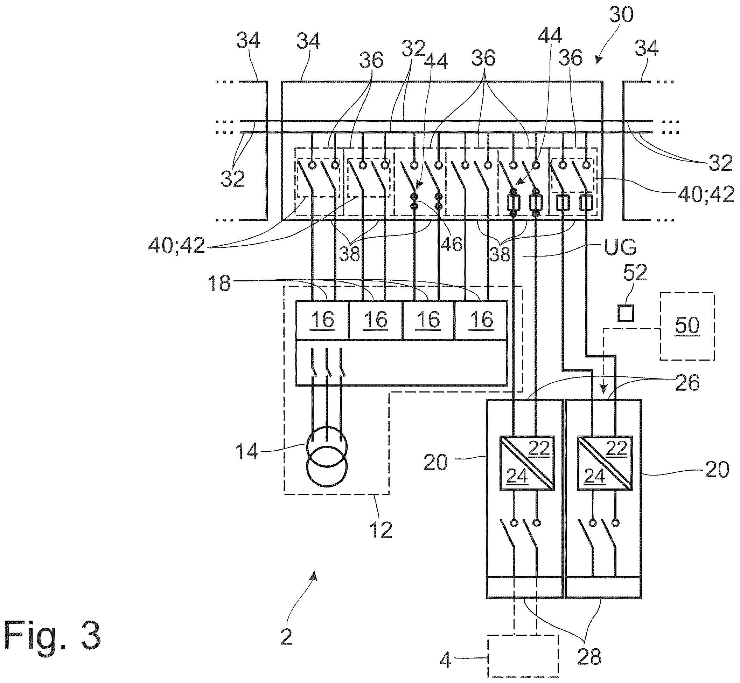

Figur 3 zeigt einen Ausschnitt des Prüffeldes 2 bzw. Gleichspannungs-Busses 30 und damit die Gleichverteiler 34 im Detail am Beispiel des mittleren Gleichverteilers 34 aus Figur 2. Im Prüffeld 2 sind alle Gleichverteiler 34 gleich ausgeführt, entsprechen also demjenigen, wie er in Figur 3 im Detail dargestellt ist (ggf. mit Ausnahme der Bestückung der Brückenanschlüsse 44).

Figur 3 zeigt, wie die zweipoligen Stromschienen 32 der einzelnen Gleichverteiler 34 in Reihe geschaltet sind, um die einzige durch alle drei Gleichverteiler 34 durchgehende Stromschiene 32 zu bilden.

Figur 3 illustriert im Detail auch den Anschluss der Energiequellen 12 und Prüfstationen 20 am Gleichspannungs-Bus 30 bzw. den Gleichverteilern 34. Hierzu weisen die Gleichverteiler 34 im Beispiel jeweils sechs zweipolige Abzweige 36 auf, die jeweils einerseits an der Stromschiene 32 angeschlossen sind und andererseits an jeweiligen dritten Gleichspannungs-Schnittstellen 38 enden. Jeder der Abzweige 36 enthält einen jeweiligen zweipoligen Trennschalter 40. Dieser dient dazu, die jeweilige dritte Gleichspannungs-Schnittstelle 38 mit der Stromschiene 32 zweipolig zu verbinden oder von dieser zu trennen (nur für drei der Abzweige 36 ist der Übersichtlichkeit halber der Trennschalter 40 in der Figur mit Bezugszeichen angedeutet).

Die elektrische Verbindung zwischen Energiequellen 12 und Prüfstationen 20 mit dem Gleichspannungs-Bus 30 erfolgt im Detail derart, dass je eine der ersten Gleichspannungs-Schnittstellen 18 oder zweiten Gleichspannungs-Schnittstellen 26 mit einer der dritten Gleichspannungs-Schnittstellen 38 jeweils zweipolig verbunden ist.

Figur 3 zeigt im Detail, dass in der Energiequelle 12 für den einen Generator 14 mit Nennleistung 1 MW vier Umrichter 16 mit Nennleistungen von je 250 kW vorgesehen sind, um diese modular und somit in verbesserter Weise ausführen zu können. Die Energiequelle 12 in Figur 3 weist daher auch eine Mehrzahl, hier vier, erste Gleichspannungs-Schnittstellen 18 auf.

Jeder der Trennschalter 40 weist eine hier nicht näher dargestellte Sicherungsvorrichtung 42 gegen Wiedereinschalten auf. Für den Fall, dass einer der Trennschalter 40 also geöffnet ist, d.h. die elektrische Verbindung zwischen Stromschiene 32 und dritter Gleichspannungs-Schnittstelle 38 unterbrochen ist, ist also ein Wiedereinschalten des Trennschalter 40 bzw. ein Wiederherstellen der elektrischen Verbindung abgesichert, um in fachüblicher Weise hier Unfälle zu vermeiden etc.

Für zwei der Abzweige 36 ist in Figur 3 beispielhaft angedeutet, dass diese bezüglich jeweils beider Pole je einen Brückenanschluss 44 enthalten. Der Brückenanschluss trennt die Verbindung zwischen Stromschiene 32 und dritter Gleichspannungs-Schnittstelle 38 hier jeweils einpolig auf, sodass zunächst keine elektrische Verbindung zwischen beiden Elementen besteht. In den Brückenanschluss 44 ist wahlweise jedoch ein Kurzschlusselement 46 oder ein Sicherungselement 48 eingesetzt.

Vorliegend sind für die vier in der Figur linken Abzweige 36 jeweils zwei Kurzschlusselemente 46 eingesetzt, um die jeweilige elektrische Verbindung zwischen Stromschiene 32 und dritter Gleichspannungs-Schnittstelle 38 über den Brückenanschluss 44 wieder zu schließen. In den beiden rechten Abzweigen 36 sind je zwei Sicherungselemente 48 eingesetzt. Die Abzweige 36 sind daher so konfiguriert, um die Energiequelle 12 über Kurzschlusselemente 46, die Prüfstationen 20 jedoch über Sicherungselemente 48 und somit in fachüblicher Weise elektrisch abgesichert, mit der Stromschiene 32 zu verbinden. Die Sicherungselemente 48, hier DC-Sicherungen sind in nicht dargestellter Weise gegenüber benachbarten Stromfaden / Polen abgeschottet.

Das Prüffeld 2 enthält hier eine Vorladeeinrichtung 50. Diese ist wahlweise zu einem bestimmten Zeitintervall mit genau einer der Prüfstationen 20 verbindbar und zu folgender Vorgehensweise eingerichtet: Wenn bei geöffnetem Trennschalter 40 die Prüfstation 20 über ihre zweite Gleichspannungs-Schnittstelle 26 mit der dritten Gleichspannungs-Schnittstelle 38 verbunden wurde, wird vor Anschaltung an die Stromschiene 32, d.h. Schließen des Trennschalters 40, eine elektrische Vorladung 52 in die Prüfstation 20 eingespeist. Zum Beispiel werden interne Kapazitäten in der Prüfstation 20 aufgeladen. So wird verhindert, dass beim nachfolgenden Schließen des Trennschalters 40 ein unerwünscht hoher Anschaltstrom zwischen Stromschiene 32 und Prüfstation 20 fließt.

### Bezugszeichen

- 2: Prüffeld
- 4: Prüfling
- 6: Stark-Leistung
- 8: Prüfvorrichtung
- 10: DUT
- 12: Energiequelle
- 14: Generator
- 16: Umrichter
- 18: erste Gleichspannungs-Schnittstelle
- 20: Prüfstation
- 22: Resonanzkonverter
- 24: Tiefsetzsteller
- 26: zweite Gleichspannungs-Schnittstelle
- 28: Gleichspannungs-Anschluss
- 30: Gleichspannungs-Bus
- 32: Stromschiene
- 34: Gleichverteiler
- 36: Abzweig
- 38: dritte Gleichspannungs-Schnittstelle
- 40: Trennschalter
- 42: Sicherungsvorrichtung (Wiedereinschalten)
- 44: Brückenanschluss
- 46: Kurzschlusselement
- 48: Sicherungselement
- 50: Vorlade-Einrichtung
- 52: Vorladung

- UW: Wechselspannung
- UG: Gleichspannung

## Patentansprüche

1. Prüffeld (2) für zweipolige Prüflinge (4), zum elektrischen Test der Prüflinge (4) mit Hilfe einer in diese einzuspeisenden und / oder aus diesen abzuführenden elektrischen Stark-Leistung unter Gleichspannung (UG),
- mit wenigstens einer Energiequelle (12),
- wobei jede der Energiequellen (12) einen Generator (14) für eine Wechselspannung (UW), und einen an den Generator (14) angeschlossenen Umrichter (16) enthält, der an seiner dem Generator (14) abgewandten Seite wenigstens eine erste zweipolige Gleichspannungs-Schnittstelle (18) enthält,
- mit einer Mehrzahl von zweipoligen Prüfstationen (20) für je einen der Prüflinge (4),
- wobei jede der Prüfstationen (20) einen Resonanzkonverter (22) mit einer zweiten zweipoligen Gleichspannungs-Schnittstelle (26) enthält, und einen an den Resonanzkonverter (22) angeschlossenen Tiefsetzsteller (24) enthält, der an seiner dem Resonanzkonverter (22) abgewandten Seite einen zweipoligen Gleichspannungs-Anschluss (28) für den jeweiligen Prüfling (4) enthält,
- mit einem modularen Gleichspannungs-Bus (30), der eine Reihenschaltung von mindestens zwei Gleichverteilern (34) enthält,
- wobei jeder der Gleichverteiler (34) eine zweipolige, in Reihe schaltbare Stromschiene (32) enthält und wenigstens zwei, an der Stromschiene (32) angeschlossene zweipolige Abzweige (36) enthält, die von der Stromschiene (32) zu einer jeweiligen dritten zweipoligen Gleichspannungs-Schnittstelle (38) führen, wobei jeder der Abzweige (36) einen zweipoligen Trennschalter (40) enthält,
- wobei jede der ersten (18) und zweiten Gleichspannungs-Schnittstellen (26) jeweils an einer der dritten Gleichspannungs-Schnittstellen (38) angeschlossen ist.

2. Prüffeld (2) nach Anspruch 1,
**dadurch gekennzeichnet, dass**
wenigstens einer der Trennschalter (40) eine Sicherungsvorrichtung (42) gegen Wiedereinschalten aufweist.

3. Prüffeld (2) nach einem der vorhergehenden Ansprüche,
**dadurch gekennzeichnet, dass**
wenigstens einer der Abzweige (36) bezüglich zumindest eines Pols einen - eine Verbindung zwischen Stromschiene (32) und dritter Gleichspannungs-Schnittstelle (38) auftrennenden - Brückenanschluss (44) enthält, in den wahlweise ein Kurzschlusselement (46) des Prüffeldes oder ein elektrisches Sicherungselement (48) des Prüffeldes überbrückend einsetzbar ist.

4. Prüffeld (2) nach einem der vorhergehenden Ansprüche,
**dadurch gekennzeichnet, dass**
das Prüffeld (2) eine Vorladeeinrichtung (50) enthält, die wahlweise mit einer der Prüfstationen (20) verbindbar ist und die dazu eingerichtet ist, in die aktuell verbundene Prüfstation (20) eine elektrische Vorladung (52) einzuspeisen.

5. Prüffeld (2) nach einem der vorhergehenden Ansprüche,
**dadurch gekennzeichnet, dass**
wenigstens eine der Energiequellen (12) eine Mehrzahl von ersten Gleichspannungs-Schnittstellen (18) aufweist.

6. Prüffeld (2) nach einem der vorhergehenden Ansprüche,
**dadurch gekennzeichnet, dass**
alle Gleichverteiler (34) gleich ausgeführt sind.

7. Prüffeld (2) nach einem der vorhergehenden Ansprüche,
**dadurch gekennzeichnet, dass**
das Prüffeld (2) wenigstens zwei Energiequellen (12) enthält.

8. Prüffeld (2) nach Anspruch 7,
**dadurch gekennzeichnet, dass**
wenigstens zwei der Energiequellen (12) an zwei verschiedenen Gleichverteilern (34) angeschlossen sind.

9. Prüffeld (2) nach einem der vorhergehenden Ansprüche,
**dadurch gekennzeichnet, dass**
an wenigstens einem der Gleichverteiler (34) keine der Energiequellen (12) angeschlossen ist.
